# EUROPEAN PATENT APPLICATION

(11) **EP 0 844 661 A1**
(43) Date of publication of application: **27.05.1998**
(21) Application number: 96830590.4
(22) Date of filing: 20.11.1996
(51) Int. Cl.: H01L 21/8238

(54) **A process for the production of silicon gate CMOS transistors, and resultant product**

(71) Applicant: SGS-THOMSON MICROELECTRONICS s.r.l., 20041 Agrate Brianza (Milano) (IT)
(72) Inventor: Depetro, Riccardo, 28037 Domodossola, Novara (IT); Andreini, Antonio, 20040 Usmate Velate, Milano (IT)
(74) Representative: Maggioni, Claudio

(57) **Abstract**

A process is described for the production of silicon gate CMOS transistors in which, after formation of strips (14n, 14p) of polycrystalline silicon for the gate electrodes on the active areas intended for the n-channel and p-channel transistors, an implantation mask (15) is formed which leaves exposed the active areas for the n-channel transistors and the associated strips (14n) of polycrystalline silicon up to the zones (14z) where these are intended to be contacted by respective metal electrodes, in such a way as to dope with n-type impurities not only the source and drain regions but also the polycrystalline silicon strips (14n). A similar operation allows both the source and drain regions of the p-channel transistors and the associated strips (14p) of polycrystalline silicon for the gate electrodes up to the respective contact zones for the metal electrodes to be doped with p-type impurities. In this way p-channel transistors having lower threshold voltages than those obtainable with the usual processes are obtained without additional operations.

## Description

The present invention relates to the production of integrated circuits and more particularly to a process for the production of silicon gate CMOS transistors according to the preamble of Claim 1, and an integrated circuit which can be obtained with this process.

The letters CMOS (complementary metal oxide semiconductor) identify an integrated circuit production technology in which both n-channel and p-channel MOS field-effect transistors are present on the same substrate.

The threshold voltage of a MOS field-effect transistor is the gate-source voltage at which reversal of the conductivity of the channel occurs, that is to say, for an enhancement transistor, the voltage at which a significant current can start to flow between source and drain. As is known, the threshold voltage depends on the geometry of the transistor, the doping of the body region, that is to say the region in which the channel is formed, the physical characteristics of the materials which constitute the gate dielectric and electrode, and the type of charge carriers present in the channel.

The threshold voltage of p-channel transistors made by the normal production processes is higher (in absolute value) than that of n-channel transistors. To obtain a lower threshold voltage for p-channel transistors, possibly even the same as that of n-channel transistors, as is required in certain applications, the surface concentration of the channel of p-channel transistors is usually reduced with a suitable doping of the body region (of n-type). This requires a masking operation and an implantation operation expressly for this purpose.

An object of the present invention is to provide a new method, which can be used in combination with or as an alternative to the known method, to obtain lower threshold voltages for p-channel transistors which does not require supplementary operations.

This object is achieved according to the invention by means of the process defined and characterised in Claim 1.

The invention will be better understood from the following detailed description of an exemplary, and therefore in no way limitative, embodiment described in relation to the attached drawings, in which
Figures from 1 to 1g are sectional views which illustrate various production phases of an n-channel transistor and a p-channel transistor according to the process of the invention;
Figure 2 is a plan view corresponding to the production phase of Figure 1d;
Figure 3 is a plan view corresponding to the production phase of Figure 1g; and
Figure 4 is a view partly in section and partly in perspective of the structure of an inverter formed with the process according to the invention.

With reference to the drawings, in particular to Figures 1a to 1g, a substrate 10 of n-type monocrystalline silicon is preliminarily provided with areas intended to contain n-channel transistors and p-channel transistors both of enhancement type.

In this description n-type substrate means a slice of monocrystalline silicon of one or other conductivity type, possibly already treated in such a way as to have an n-type layer, delimited by a major surface of the substrate, obtained for example by epitaxial growth on the starting silicon. The said preparation of the areas consists in forming p-type regions 11 (p-wells) for the n-channel transistors and insulating plates 12 (silicon dioxide) by means of the known technique of local oxidation of the silicon. These plates delimit the areas intended for active devices, among them the CMOS transistors. Figure 1a represents in section two parts of the substrate 10 intended, respectively, for an n-channel transistor and a p-channel transistor, in this stage of the production process.

A thin layer of silicon dioxide and a layer of polycrystalline silicon, respectively indicated 13 and 14 in Figure 1b are then formed by growth or by deposition. At this point, according to the known technique, the polycrystalline silicon would be doped with n-type impurities to obtain an electro-conductive layer. The process according to the invention does not, on the other hand, envisage this operation. With a photolithographic operation the polycrystalline silicon is selectively removed leaving, on each of the active areas intended for p-channel transistors and n-channel transistors, a layer, respectively 14n and 14p, which divides the respective active areas into two portions and is intended to form the gate electrode of the corresponding transistor (Figure 1c).

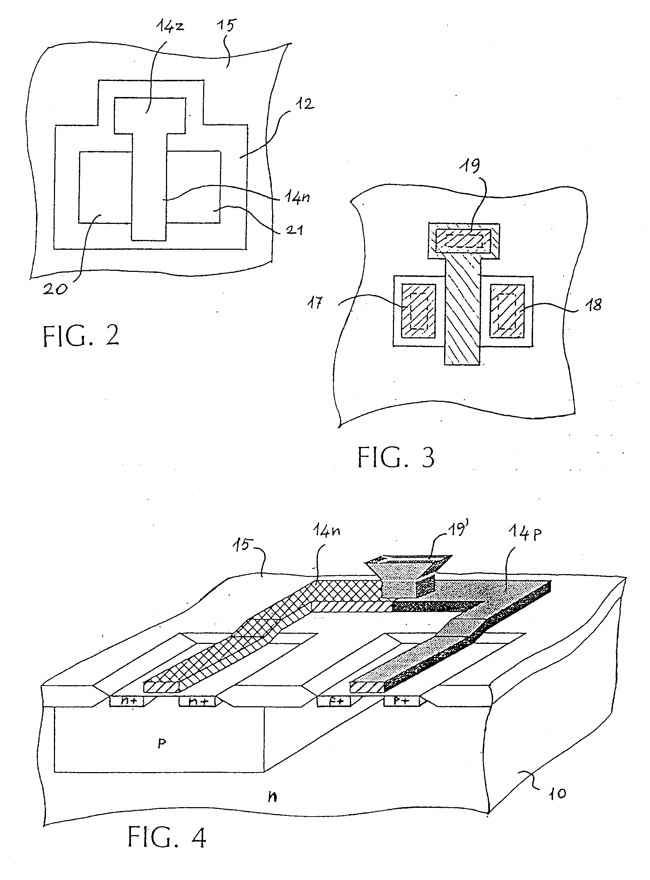

A photoresist mask 15 is then formed, which covers the areas intended for p-channel transistors leaving exposed the areas intended for the n-channel transistors and the associated gate strips 14n up to the zones 14z of these which will be contacted by a metallic contact electrode. The resultant structure is shown in section in Figure 1d and in plan, but only for the part intended for the n-channel transistor, in Figure 2.

Through this mask 15 there is performed an ion implantation of an n-type doping impurity which is represented with parallel arrows in Figure 1d. Note that the oxide layer 13 is very thin and therefore does not constitute a significant screen for the ion implantation, but rather has a positive effect in that it limits the damage to the crystalline surface structure of the silicon which could be caused by the implantation. Naturally, if necessary, this layer can easily be removed with a suitable chemical attack on the areas to be implanted. The polycrystalline silicon strip 14n is, on the other hand, sufficiently thick to block the implantation of ions into the underlying monocrystalline silicon.

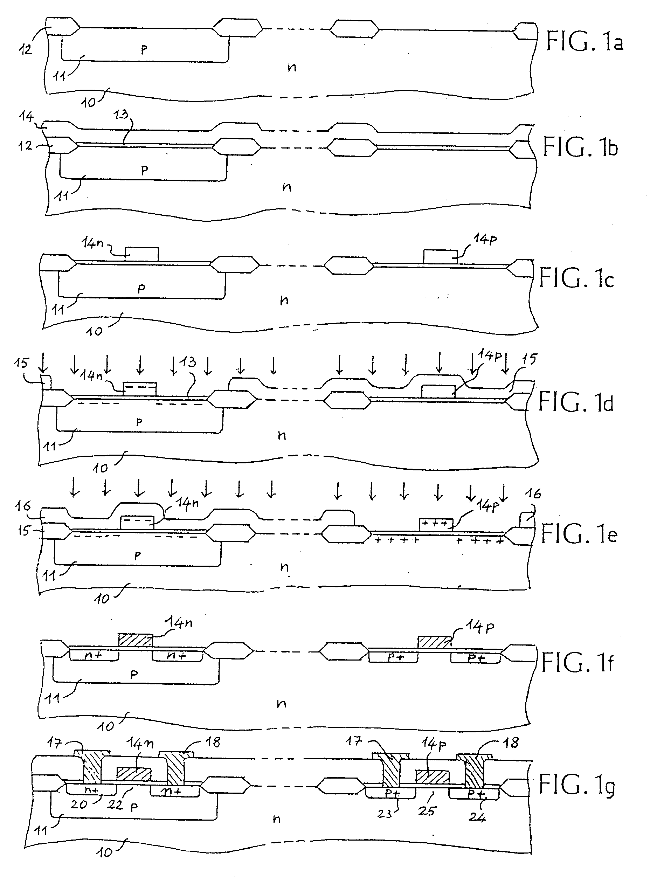

The mask 15 is then removed and another, indicated 16, is formed, which covers the areas intended for n-channel transistors leaving exposed the areas intended for the p-channel transistors with the associated gate strips, also up to the zones which will be contacted by a metallic element. The resultant structure is represented in section in Figure 1e and is the same, in plan, as that intended for the n-channel transistor of Figure 2.

Ion implantation of a p-type doping impurity is then performed, which is represented with the parallel arrows in Figure 1e and the second mask 16 is then also removed.

In this case too, the polycrystalline silicon strip 14p is sufficiently thick to block implantation of ions into the underlying monocrystalline silicon.

Naturally, the masking and n-type impurity doping operations and the masking and p-type impurity doping operations could be performed in reverse order.

In this example, the n-type and p-type impurities thus implanted are caused to diffuse by a high temperature treatment to obtain regions 20 and 21 strongly doped with n-type impurities, and thus indicated n+, separated by a channel 22 aligned with the overlying strip of polycrystalline silicon 14n, which constitute the drain and source regions of the n-channel transistors, and regions 23 and 24 strongly doped with p-type impurities, and thus indicated p+, separated by a channel 25 aligned with the overlying strip 14p of polycrystalline silicon, which constitute the drain and source regions of the p-channel transistors.

As is known to those skilled in the art, the formation of the drain and source regions of the transistors can also be obtained with more than one heat treatment, each executed for example after implantation, or even without a specific high temperature treatment.

There is thus obtained a structure, represented in Figure 1f, in which the strips 14n of the gate electrodes of the n-channel transistors are n-doped and those 14p of the p-channel transistors are p-doped.

Contact electrodes of the source 17 drain 18 and gate 19, of the transistors are formed with normal operations of deposition of silicon dioxide, masking, attack, deposition of aluminium and selective removal of the aluminium in such a way as to obtain the structure illustrated in section in Figure 1g and in plan in Figure 3. Note that Figure 3 represents both the n-channel transistor and the p-channel transistor.

The effect of the p-type doping of the gate electrode 14p of the p-channel transistor is to give a lower threshold voltage than that which it would have had with the usual n-type doping because one of the quantities which determine the threshold voltage, namely the difference between the working functions of the monocrystalline silicon and the strongly doped polycrystalline silicon is lower for the p-doped polycrystalline silicon than for n-doped polycrystalline silicon. There is thus obtained, according to the invention, a lowering of the threshold voltage of the p transistors without any additional operation in the production process.

In many circuit configurations it is necessary to connect together the gate electrodes of the n-channel transistors and the gate electrodes of the p-channel transistors, for example in the case of two complementary transistors connected in the inventor configuration. The most convenient and also the most usual way of connecting together the gate electrodes is by forming them in a single strip of polycrystalline silicon. With a structure according to the invention, however, the strips of polycrystalline silicon which constitute the gate electrodes are doped with impurities of opposite type so that they would form a diode in the border region between n-doped silicon and p-doped silicon.

To avoid the unwanted effects of this diode, in an embodiment of the invention the metallic electrodes in contact with respective strips are electrically connected together. Preferably there is formed a single metallic electrode, common to the two strips, in contact with adjacent zones of the border region between n-silicon and p-silicon in such a way as to short circuit the np junction. An inverter structure with a connection of this type is shown, partly in perspective and partly in section, in Figure 4, in which the same elements as those of Figures from 1 to 3 are indicated with the same reference numerals and the common metallic electrode is indicated 19'.

## Claims

1. A process for the production of complementary MOS transistors with silicon gates on a substrate (10) of semiconductor material comprising the steps of
preparing first and second areas on the substrate (10) isolated from one another and intended to contain, respectively, n-channel transistors and p-channel transistors,
forming on the first and second areas a layer (13) of dielectric material for the gate dielectric of the n-channel transistors and the p-channel transistors,
forming on the layer of dielectric material a layer (14) of polycrystalline silicon for the gate electrodes of the n-channel transistors and the p-channel transistors,
selectively removing the polycrystalline silicon in such a way as to leave on each of the first and second areas a strip (14n, 14p) of polycrystalline silicon which delimits two portions of the area,
introducing doping impurities of n-type into the two portions of the first areas to form source and drain regions (20, 21) of the n-channel transistors,
introducing p-type doping impurities into the two portions of the second areas to form source and drain regions (23, 24) of the p-channel transistors,
forming a plurality of metallic electrodes (19) each in contact with one zone (14z) of the polycrystalline silicon strip of at least some of the first and second areas,
characterised in that,
to introduce n-type doping impurities into the two portions of the first areas a first mask (15) of material impermeable to the implantation, which covers the second areas and has apertures which leave exposed the first areas and the respective strips (14n) of polycrystalline silicon up to the zones (14z) intended to be contacted by respective metal electrodes (19), is formed and n-type impurities are implanted and diffused through the apertures of the first mask (15) to obtain source and drain regions (20, 21) of the n-channel transistors and strips of n-doped polycrystalline silicon (14n) which constitute the gate electrodes of the n-channel transistors and,
to introduce p-type doping impurities into the two portions of the second areas a second mask (16) of material impermeable to implantation which covers the first areas and has openings which leave exposed the second areas and the respective strips (14p) of polycrystalline silicon up to the zones (14p) intended to be contacted by respective metallic electrodes (19), is formed and p-type impurities are implanted and diffused through the apertures of the second mask (16) to obtain source and drain regions (23, 24) of the p-channel transistors and strips (14p) of p-doped polycrystalline silicon which constitute the gate electrodes of the p-channel transistors.

2. An integrated circuit with complementary silicon gate MOS transistors on a substrate (10) of semiconductor material comprising
first and second areas insulated from one another containing, n-channel transistors and p-channel transistors respectively,
a plurality of strips (14n, 14p) of doped polycrystalline silicon each of which extends over one of the first and second areas, is separated from the substrate (10) by a dielectric (13), divides the respective areas into two portions and constitutes the gate electrode of the respective transistor,
for each of the first areas, two regions (20, 21) doped with n-type impurities, separated from one another by a channel (22) substantially aligned with the respective strip (14n) of polycrystalline silicon, which constitute the source and drain regions of the respective n-channel transistors,
for each of the second areas, two regions (23, 24) doped with p-type impurities, separated from one another by a channel substantially aligned with the respective strip (14p) of polycrystalline silicon, which constitute the source and drain regions of the respective p-channel transistor,
a plurality of metal electrodes (19), each in contact with a region of the polycrystalline silicon strip of at least some of the first and second areas,
characterised in that the strips (14n) of polycrystalline silicon which extend over the first areas are doped with n-type impurities up to the respective zones (14c) of contact with the metal electrodes (19) and the strips (14p) of polycrystalline silicon which extend over second areas are doped with p-type impurities up to the respective zones of contact with the metal electrodes (19).

3. An integrated circuit according to Claim 2, in which at least one strip (14n) of polycrystalline silicon doped with n-type impurities is integrally connected to a strip (14p) of polycrystalline silicon doped with p-type impurities and in which the respective metal electrodes (19) are electrically connected together.

4. An integrated circuit according to Claim 3, in which the electrically connected metal electrodes (19) are formed by a single electrode (19') common to the two integrally connected strips (14n, 14p).
